Europäisches Patentamt

European Patent Office

Office européen des brevets

(19)

(11) Veröffentlichungsnummer: **0 463 231 A1**

## (12) EUROPÄISCHE PATENTANMELDUNG

(21) Anmeldenummer: **90123863.4**

(22) Anmeldetag: **11.12.90**

(51) Int. Cl.5: **H03F 3/72,** H03F 3/60

(30) Priorität: **28.06.90 EP 90112380**

(43) Veröffentlichungstag der Anmeldung:
**02.01.92 Patentblatt 92/01**

(84) Benannte Vertragsstaaten:
**DE FR IT**

(71) Anmelder: **SIEMENS AKTIENGESELLSCHAFT**
**Wittelsbacherplatz 2**
**W-8000 München 2(DE)**

(72) Erfinder: **Wendt, Peter, Dipl.-Ing.**
**Oblatterwallstrasse 36cl**
**W-8900 Augsburg(DE)**

(54) **Pulsleistungsverstärker.**

(57) Die Erfindung betrifft einen Pulsleistungsverstärker mit einer Treiberstufe (T1) und einer nachgeschalteten Koppelstufe (H1) zur Leistungsaufteilung auf zwei damit verbundene parallel geschaltete Endstufen sowie mit einer weiteren, die Ausgangssignale der Endstufen (T2, T3) zusammenführenden Koppelstufe (H2). Erfindungsgemäß weisen die beiden Koppelstufen (H1, H2) jeweils ein weiteres, entkoppeltes Tor (H14, H24) auf, die jeweils mit einem Umschalter (2, 4) verbunden sind.

Die weiteren Tore sind in einer ersten Schalterstellung der Umschalter mit Abschlußwiderständen (R1, R2) und in einer zweiten Schalterstellung über einen zusätzlichen Signalweg (3) miteinander verbunden und die Endstufen jeweils eingangs- und ausgangsseitig über Schaltelemente (D1,-D4) niederohmig abschließbar.

EP 0 463 231 A1

Die Erfindung betrifft einen Pulsleistungsverstärker gemäß dem Oberbegriff des Patentanspruchs 1.

Ein solcher Pulsleistungsverstärker ist aus der Application Note AV-201 von MSC (Microwave Semiconductor Corp., Juni 1978) bekannt.

Bei Pulsleistungsverstärkern, die bis in den GHz-Bereich Pulsspitzenleistungen von 200 W und mehr erzeugen, werden Hochfrequenz-Leistungstransistoren für Pulsbetrieb verwendet. Die erzielbare Pulsleistung von Einzeltransistoren ist begrenzt und liegt abhängig vom Pulsformat in der Größenordnung von 100 W. Die Transistoren arbeiten dabei aus thermischen Gründen im nichtlinearen C-Betrieb und werden nur während der Tastung in den A- oder B-Betrieb gesteuert.

Höhere Ausgangsleistungen werden durch Parallelschaltungen mit mehreren Transistoren erreicht. Die Verstärkerschaltungen enthalten dabei Koppelstufen als Entkopplungselemente und um die zu verstärkenden bzw. verstärkten Signale aufzuteilen bzw. zusammenzufassen. Als Koppelstufen werden 3-dB-Leistungsteiler oder sogenannte 3-dB-Hybride verwendet. Solche "Hybrid Coupler" sind beispielsweise aus dem Katalog der Firma ANAREN bekannt. Haben die Ausgangssignale der Hybride eine relative Phase von ± 90° oder von 0° und 180° zueinander, so spricht man von einem 90°-Hybride oder einem 180°-Hybrid. 3-dB-Leistungsteiler sind sog. Dreitore oder Viertore, welche eine an einem Tor eingespeiste Leistung auf zwei weitere Tore symmetrisch aufteilen. Bei Viertor-Leistungsteilern ist stets ein Tor entkoppelt. (Integrierte Mikrowellenschaltungen, R.K. Hoffmann, Springer Verlag, Seiten 14, 15) Dieses Tor wird in den bekannten Verstärkerschaltungen mit einem Absorberwiderstand abgeschlossen.

Bei bestimmten Anwendungen der Pulsleistungsverstärker wird nicht nur eine feste hohe Ausgangsleistung gefordert, sondern im Hinblick auf geringe Entdeckbarkeit und unterschiedliche zu überbrückende Entfernungen ist ein maximaler und ein minimaler Wert der abgegebenen Pulsleistung gefordert. Die abgegebene Pulsleistung kann hierbei sich um 10 bis 30 dB unterscheiden.

Es ist denkbar, die vom Pulsleistungsverstärker abgegebene Ausgangsleistung zu reduzieren, in dem die Ansteuerleistung eines der beiden parallelgeschalteten Endstufentransistoren mittels eines Umschalters abgeschaltet wird. Als Umschalter kann hierbei ein sogenannter SPDT-Schalter (siehe Application of PIN Diodes, Application Note 922 von Hewlett Packard) verwendet werden. Die Schalterverluste müssen dabei durch eine erhöhte Treiberleistung ausgeglichen werden. Bei reduzierter Ausgangsleistung arbeitet der eingeschaltete Endstufentransistor weiterhin bei voller Verstärkung und Leistung, was sich ungünstig auf den Wirkungsgrad und die Zuverlässigkeit der Gesamtschaltung auswirkt.

Der Erfindung liegt die Aufgabe zugrunde, einen Pulsleistungsverstärker anzugeben, der auf stark unterschiedliche Ausgangsleistungsstufen einstellbar ist.

Diese Aufgabe wird erfindungsgemäß durch die im Patentanspruch angegebenen Merkmale gelöst.

Bei dem erfindungsgemäßen Pulsleistungsverstärker werden Änderungen des Impulsspektrums durch Regelverzerrungen der Endstufe vermieden. Es kann weiter eine definierte Impulsform durch eine entsprechende Impulsformung bei der Verstärkung eingehalten werden.

Ein weiterer Vorteil besteht darin, daß bei Abgabe der maximalen Spitzenpulsleistung keine Dämpfungsverluste durch Schalteranordnungen kompensiert werden müssen.

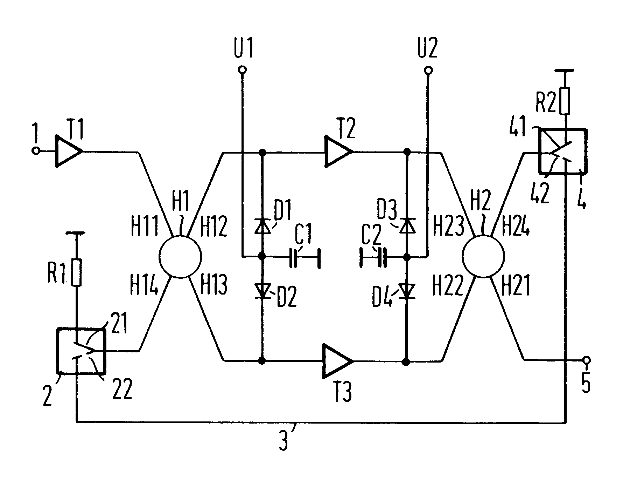

Im folgenden wird die Erfindung anhand eines in der Zeichnung dargestellten Ausführungsbeispieles erläutert.

In der einzigen Figur liegt der zu verstärkende Eingangsimpuls an einem Eingang 1 einer Treiberstufe T1 an. Die Treiberstufe T1 kann zur Steuerung oder Regelung der Ausgangsleistung bei gleichzeitiger Impulsformung ausgebildet sein. Solche Verfahren zur Modulation von Hochfrequenz-Leistungstransistoren sind allgemein bekannt.

Die Treiberstufe T1 ist ausgangsseitig mit einem Eingangstor H11 einer Koppelstufe H1 verbunden. Diese Koppelstufe H1 ist ein sogenanntes 3dB/90°-Hybrid der eingangs beschriebenen Art, bei dem stets ein Tor entkoppelt ist. Die durch Fehlabschlüsse an den Ausgangstoren reflektierte Leistung tritt am entkoppelten Tor H14 auf. Dieses entkoppelte Tor H14 ist mit einem Umschalter 2 verbunden.

Die beiden Ausgangstore H12, H13 der Koppelstufe H1 dienen zur symmetrischen Aufteilung des Signals auf zwei Endstufen T2 und T3. Als Endstufen T2, T3 werden beispielsweise Hochfrequenz-Leistungstransistoren verwendet, die im nichtlinearen C-Betrieb zur Pulsleistungsverstärkung arbeiten. Die Ausgangssignale der Endstufen T2, T3 werden über zwei Tore H22, H23 einer weiteren Koppelstufe H2 wieder zusammengefaßt, und über ein Tor H21 als Ausgangspuls an einem Ausgang 5 abgegeben. Auch die Koppelstufe H2 ist ein sog. 3dB/90°-Hybrid, dessen entkoppeltes Tor H24 mit einem Umschalter 4 verbunden ist. Die Umschalter 2, 4 sind beispielsweise durch die eingangs beschriebenen SPDT-Schalter realisiert.

Über Dioden D1 bis D4, beispielsweise PIN-Dioden, können die Endstufen T2, T3 und somit die Koppelstufen H1, H2 eingangs- und ausgangsseitig niederohmig abgeschlossen werden. Hierzu liegt eine Steuerspannung U1 an einem Kondensator C1 und über die beiden in Flußrichtung gepolten Dioden D1 und D2 an den Eingängen der Endstufen T2, T3 an. Ausgangsseitig liegt eine weitere Steuerspannung U2 an einem Kondensator C2 und über ebenfalls in Flußrichtung gepolte Dioden D3 und D4 an den Ausgängen der Endstufen T2, T3 an. Es ist prinzipiell denkbar, daß die Endstufen T2, T3 über eine eingangsseitige bzw. ausgangsseitige Diodenanordnung von den Koppelstufen H1, H2 abgetrennt und folglich die Koppelstufen H1, H2 eingangs- und ausgangsseitig hochohmig abgeschlossen werden.

In einer ersten Schalterstellung 21, 41 der beiden Umschalter 2, 4 sind die beiden entkoppelten Tore H14, H24 der Koppelstufen H1, H2 jeweils mit einem Abschlußwiderstand R1, R2 verbunden. In einer zweiten Schalterstellung 22, 42 der beiden Umschalter 2, 4 sind die beiden Tore H14, H24 der Koppelstufen H1, H2 über einen zusätzlichen Signalweg 3 miteinander verbunden.

Beim Betrieb mit maximaler Signalverstärkung befinden sich die beiden Umschalter 2, 4 jeweils in ihrer ersten Schalterstellung 21, 41, und die Endstufen T2, T3 sind gleichstrom- und hochfrequenzmäßig eingeschaltet. Die Dioden D1 bis D4 sind durch die Steuerspannungen U1, U2 gesperrt und weisen einen im Vergleich zu 50Ω hohen Hochfrequenz-Widerstand auf. Die Einfügungsdämpfung jeder Diode ist bei entsprechender Technologie und Gehäusebauform im Bereich von 0,1 dB. Am Ausgang 5 wird die maximale Leistung abgegeben.

Beim Betrieb mit minimaler Signalverstärkung befinden sich die beiden Umschalter 2, 4 jeweils in ihrer zweiten Schalterstellung 22, 42, und die Endstufen T2, T3 können gleichstrommäßig abgeschaltet sein, was sich günstig auf die Zuverlässigkeit auswirkt. Die Dioden D1 bis D4 sind über die Steuerspannungen U1, U2 in einen Bereich mit einem im Vergleich zu 50Ω niederohmigen Hochfrequenz-Widerstand gesteuert. Die von der Treiberstufe T1 an die Koppelstufe H1 abgegebene Leistung wird aufgrund der Fehlanpassung an den Dioden D1, D2 reflektiert, über die Umschalter 2, 4 und den zusätzlichen Signalweg 3 in die weitere Koppelstufe H2 eingespeist, an den Dioden D3, D4 reflektiert, und schließlich am Ausgang 5 abgegeben.

Die erforderliche Sperrdämpfung der Umschalter 2, 4 ist beim Betrieb mit maximaler Signalverstärkung wegen der vergleichsweise geringen Verstärkung der Endstufen T2, T3 nicht höher als 20 dB. Der Leistungsverlust beim Betrieb mit reduzierter Ausgangsleistung beträgt etwa 2 bis 3 dB. Die Pulsform wird allein von der modulierten Treiberstufe T1 bestimmt, und wird nicht durch Regelverzerrungen der Endstufen T2, T3 beeinflußt.

## Bezugszeichenliste

| | |
|---|---|
| T1 | Treiberstufe |
| T2, T3 | Endstufen |
| H1, H2 | Koppelstufen |
| H11-H14, H21-H24 | Tore |
| D1-D4 | Dioden |
| R1, R2 | Abschlußwiderstände |
| C1, C2 | Kondensatoren |
| K1, K2 | Steuerspannungen |
| 1 | Eingang |
| 2 | Umschalter |
| 3 | zusätzlicher Signalweg |
| 4 | Umschalter |
| 5 | Ausgang |

**Patentansprüche**

3

1. Pulsleistungsverstärker

mit einer Treiberstufe (T1), an der der zu verstärkende Eingangspuls anliegt,

mit einer der Treiberstufe (T1) nachgeschalteten Koppelstufe (H1) zur Leistungsaufteilung auf zwei damit verbundene parallel geschaltete Endstufen (T2,T3),

mit einer weiteren, die Ausgangssignale der Endstufen (T2, T3) zusammenführenden Koppelstufe (H2) an der der Ausgangspuls abgreifbar ist,

**dadurch gekennzeichnet,** daß

die beiden Koppelstufen (H1, H2) jeweils ein weiteres, entkoppeltes Tor (H14, H24) aufweisen, die jeweils mit einem Umschalter (2, 4) verbunden sind,

die weiteren Tore (H14, H24) in einer ersten Schalterstellung (21, 41) der Umschalter (2, 4) mit Abschlußwiderständen (R1, R2), und in einer zweiten Schalterstellung (22, 42) über einen zusätzlichen Signalweg (3) miteinander verbunden sind, und die Endstufen (T2, T3) jeweils eingangs- und ausgangsseitig über Schaltelemente (D1 bis D4) niederohmig abschließbar sind.

# EUROPÄISCHER RECHERCHENBERICHT

Nummer der Anmeldung

**EP 90 12 3863**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | FR-A-2 284 226   (THOMSON-CSF) <br> * das ganze Dokument * <br> — — — | 1 | H 03 F 3/72 <br> H 03 F 3/60 |
| A | US-A-3 789 314   (H.R. BEURRIER) <br> * Spalte 2, Zeile 16 - Spalte 4, Zeile 16; Abbildungen 1,2 * <br> — — — — — | 1 | |
| | | | **RECHERCHIERTE SACHGEBIETE (Int. Cl.5)** |
| | | | H 03 F |

Der vorliegende Recherchenbericht wurde für alle Patentansprüche erstellt

| Recherchenort | Abschlußdatum der Recherche | Prüfer |
|---|---|---|
| Den Haag | 17 September 91 | TYBERGHIEN G.M.P. |